# FASCICULE DE BREVET EUROPEEN

(11) **EP 2 075 224 B1**
(45) Date de publication et mention de la délivrance du brevet: **11.06.2014**
(21) Numéro de dépôt: 08172570.7
(22) Date de dépôt: 22.12.2008
(51) Int. Cl.: B81B 3/00

(54) **Procédé de réalisation d'un dispositif micromécanique ou nanomécanique à butées anti-collage**
Verfahren zur Herstellung eines mikomechanischen oder nanomechanischen Elements mit Anti-Haft-Anschlägen
Method for manufacturing a micromechanical or nanomechanical device with anti-stiction bumps

(30) Priorité: 27.12.2007 FR 0760402
(43) Date de publication de la demande: 01.07.2009
(73) Titulaire: Commissariat à l'Énergie Atomique et aux Énergies Alternatives, 75015 Paris (FR)
(72) Inventeur: Caplet, Stéphane, 38360, SASSENAGE (FR)
(74) Mandataire: Ilgart, Jean-Christophe

(56) Documents cités:
- EP-A- 0 754 953
- EP-A- 1 857 406
- FUJITSUKA N ET AL: "A new processing technique to prevent stiction using silicon selective etching for SOI-MEMS" SENSORS AND ACTUATORS A, ELSEVIER SEQUOIA S.A., LAUSANNE, CH, vol. 97-98, 1 avril 2002 (2002-04-01), pages 716-719, XP004361671 ISSN: 0924-4247

## Description

### DOMAINE TECHNIQUE

L'invention concerne le domaine des dispositifs micromécaniques et/ou nanomécaniques comportant des éléments mobiles, et plus particulièrement celui des microsystèmes électromécaniques (MEMS) et/ou des nanosystèmes électromécaniques (NEMS) comportant des éléments mobiles susceptibles d'entrer en contact avec d'autres éléments du MEMS et/ou NEMS durant son fonctionnement.

### ÉTAT DE LA TECHNIQUE ANTÉRIEURE

Certains dispositifs micromécaniques ou nanomécaniques, tels que des MEMS ou NEMS (par exemple des accéléromètres ou des gyromètres), comportent des éléments mobiles permettant par exemple de réaliser des mesures physiques telles qu'une accélération subie par un tel MEMS ou NEMS. Ces mesures physiques sont obtenues grâce aux mouvements relatifs de ces éléments mobiles par rapport à d'autres éléments du MEMS ou NEMS. Il est donc important que ces éléments mobiles soient maintenus à distance des autres éléments du MEMS ou NEMS pour préserver leur liberté de mouvement. Toutefois, compte tenu de cette liberté de mouvement, les éléments mobiles sont susceptibles de venir en contact avec les autres éléments, fixes ou mobiles, du MEMS ou NEMS, pouvant ainsi entraîner un « collage » des éléments entre eux. En cas de collage, le mouvement des éléments mobiles n'est plus assuré durant le fonctionnement du MEMS ou NEMS, le rendant alors défaillant.

Un tel collage peut également apparaître lors de la réalisation du dispositif, et notamment durant une étape de séchage de solvants utilisés pour le rinçage de la structure après la mise en oeuvre d'étapes de gravure humide.

Pour empêcher ces collages intempestifs, il est connu former des pions, ou butées, anti-collage sur les surfaces des éléments du MEMS ou NEMS qui sont susceptibles de venir en contact les unes avec les autres. Ces pions anti-collage permettent notamment de limiter la surface de contact en cas de collision et donc de réduire les risques de collage des éléments mobiles du MEMS.

Le document EP 0 754 953 A1 décrit un procédé de réalisation de pions anti-collage sur la surface d'une structure qui est formée dans une couche utile à base de silicium disposée sur une couche d'oxyde de silicium et un substrat de silicium. Ce procédé comporte une première étape de gravure à l'acide fluorhydrique de la couche d'oxyde pour former des espaceurs à base d'oxyde de silicium entre le substrat et la couche utile. La couche utile et le substrat sont ensuite gravés par gravure humide, par exemple avec une solution de potasse, les espaceurs formant alors des masques de gravure. Cette seconde étape de gravure forme les pions anti-collage dans la couche utile et dans le substrat. On élimine enfin les espaceurs, libérant ainsi complètement la structure, réalisée dans la couche utile, du substrat.

Ce procédé a notamment pour inconvénient de rendre rugueuses les surfaces de la structure soumises aux agents de gravure, par exemple la face avant de la couche utile. Une telle rugosité peut poser des problèmes, notamment pour la mise en oeuvre ultérieure d'opérations sur ces surfaces, par exemple un scellement direct (ou scellement moléculaire) d'un capot recouvrant la structure sur la face avant de la couche utile.

### EXPOSÉ DE L'INVENTION

Un but de la présente invention est de proposer un procédé de réalisation d'un dispositif micromécanique et/ou nanomécanique à butées, ou pions, anti-collage ne présentant pas les inconvénients de l'art antérieur, et notamment ne détériorant pas les surfaces du dispositif pendant la réalisation des butées.

Pour cela, la présente invention propose un procédé de réalisation d'un dispositif micromécanique et/ou nanomécanique comportant au moins les étapes de :
- gravure partielle d'au moins une couche sacrificielle disposée entre une première couche et un substrat, formant au moins une cavité dans laquelle est disposée au moins une portion de la couche sacrificielle en contact avec la première couche et/ou le substrat,
- transformation chimique d'au moins une paroi de la première couche et/ou du substrat dans la cavité, délimitant au moins une butée dans la première couche et/ou le substrat au niveau de la portion de la couche sacrificielle,
- élimination de ladite portion de la couche sacrificielle et de la paroi transformée chimiquement de la première couche et/ou du substrat, libérant la butée.

Ainsi, on réalise un dispositif micromécanique et/ou nanomécanique comportant au moins une butée anti-collage sans détériorer les surfaces du dispositif pendant son procédé de réalisation, et notamment sans rendre rugueuses ces surfaces. Ainsi, ce procédé de réalisation est compatible avec des étapes ultérieures faisant appel en particulier à des surfaces non rugueuses, par exemple la réalisation d'un capot par scellement direct, ou adhésion moléculaire, sur le dispositif.

Selon un mode de réalisation particulier, avant l'étape d'élimination, plusieurs autres étapes peuvent être mises en oeuvre pour réaliser le dispositif micromécanique et/ou nanomécanique (dépôts, gravure,...). En particulier, lorsque l'étape de transformation chimique est réalisée à haute température, par exemple une étape de siliciuration, il peut être avantageux de mettre en oeuvre ces étapes de réalisation du dispositif entre l'étape de transformation chimique et l'étape d'élimination.

Selon un premier mode de réalisation, l'étape de transformation chimique peut comporter au moins une oxydation thermique de la paroi de la première couche et/ou du substrat.

Selon un second mode de réalisation, l'étape de transformation chimique peut comporter au moins un dépôt d'une couche métallique sur la paroi de la première couche et/ou du substrat, et une siliciuration de la couche métallique. Dans ce cas, la première couche et/ou le substrat peuvent être à base de silicium. De plus, la couche métallique peut être à base de titane et/ou de nickel. Cette siliciuration peut être obtenue par un traitement thermique à environ 700°C, par exemple pendant quelques minutes, d'une couche de titane déposée sur le silicium (couche métallique à base de titane et paroi de la première couche et/ou du substrat à base de silicium).

Ainsi, selon l'invention, l'utilisation d'une transformation chimique pour délimiter la butée avant d'éliminer le matériau transformé chimiquement permet la mise en oeuvre d'une gravure sélective du matériau transformé chimiquement par rapport au reste de la couche utile et du substrat. Par ailleurs, l'interface entre le matériau transformé et le reste de la couche utile et/ou du substrat pouvant être définie par la transformation chimique, cette interface ne présente pas les rugosités des surfaces gravées comme dans l'état de l'art décrit précédemment.

Avantageusement, la couche sacrificielle peut être à base d'au moins un matériau insensible à l'étape de transformation chimique, c'est-à-dire un matériau tel que l'étape de transformation chimique n'affecte pas ce matériau. Dans le cas d'une oxydation thermique de silicium ou d'une siliciuration de silicium, on peut choisir par exemple une couche sacrificielle à base d'oxyde de silicium.

La couche sacrificielle peut également être à base d'un matériau qui, s'il subit la transformation chimique, puisse être éliminé de façon sélective par rapport à la couche utile et/ou le substrat.

Par ailleurs, l'étape de transformation chimique permet également de nettoyer des éventuels résidus de matériau se trouvant sur le dispositif générés par les étapes précédentes.

La gravure partielle peut être réalisée à travers au moins une ouverture formée à travers la première couche.

La première couche peut être à base d'au moins un semi-conducteur et/ou la couche sacrificielle peut être à base d'au moins un oxyde de semi-conducteur et/ou le substrat peut être à base d'au moins un semi-conducteur.

La couche utile et/ou le substrat ne sont pas forcément monocouche, ni homogène. Ils peuvent par exemple comporter des éléments du dispositif réalisés avant les butées.

Avantageusement, l'étape d'oxydation peut être réalisée par un traitement thermique, par exemple par voie humide ou sèche.

De préférence, l'étape de gravure peut être obtenue par la mise en oeuvre d'une gravure humide ou en phase vapeur.

La transformation chimique de la paroi peut être réalisée sur une épaisseur comprise entre environ 200 Å et 2000 Å.

La hauteur de la butée obtenue peut correspondre à l'épaisseur éliminée de la paroi transformée chimiquement de la couche première couche et/ou du substrat.

Le procédé peut comporter en outre, après l'étape d'élimination de ladite portion de la couche sacrificielle, une étape de réalisation d'un capot sur la première couche.

L'invention s'applique particulièrement à la réalisation de microactionneurs et/ou nanoactionneurs, de micropompes et/ou nanopompes, de micromoteurs et/ou nanomoteurs, d'accéléromètres, de microcapteurs et/ou nanocapteurs, ou de tout microsystème et/ou nanosystème comportant au moins un élément mobile.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1 à 5 représentent les étapes d'un procédé de réalisation d'un dispositif micromécanique à butées anti-collage, objet de la présente invention, selon un premier mode de réalisation,
- les figures 6 et 7 représentent des étapes d'un procédé de réalisation d'un dispositif à butées anti-collage, objet de la présente invention, selon un second mode de réalisation.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

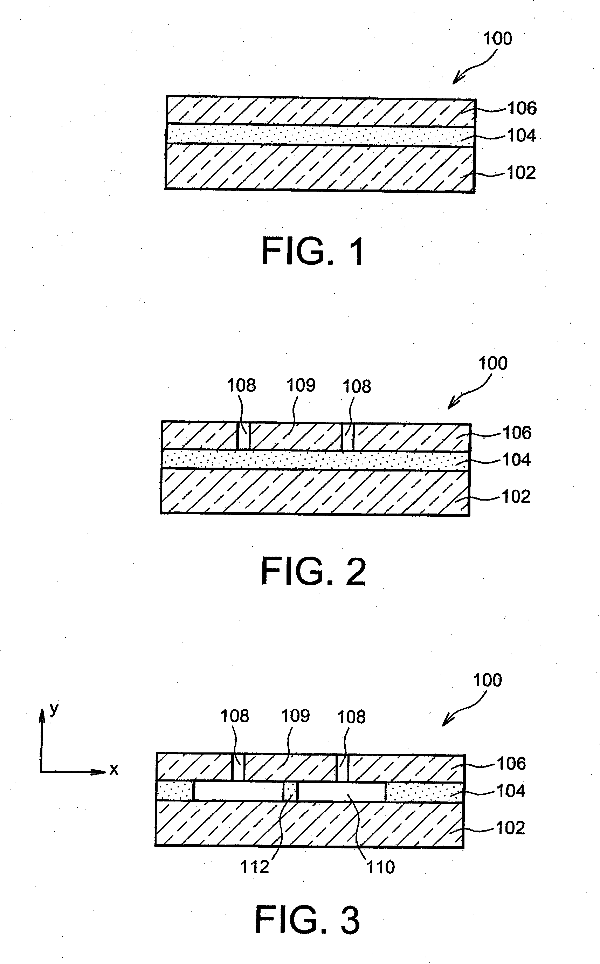

On se réfère aux figures 1 à 5 représentant les étapes d'un procédé de réalisation d'un dispositif micromécanique et/ou nanomécanique 100 à butées anti-collage selon un premier mode de réalisation.

Comme représenté sur la figure 1, un dispositif micromécanique et/ou nanomécanique 100, par exemple un MEMS, est réalisé à partir d'un substrat 102 par exemple à base d'au moins un semi-conducteur, par exemple du silicium, sur lequel est disposée une couche diélectrique 104, par exemple à base d'un oxyde tel que de l'oxyde de silicium et utilisée ici en tant que couche sacrificielle, et une couche utile 106 par exemple à base d'au moins un semi-conducteur tel que du silicium. Les couches 102, 104 et 106 forment ici un substrat SOI (silicium sur isolant). La couche sacrificielle 104 peut par exemple avoir une épaisseur égale à environ 0,4 µm, la couche utile 106 pouvant avoir une épaisseur comprise entre environ 1 µm et 200 µm.

On entend par couche utile une couche de matériau, ou une portion d'une telle couche, dans laquelle est réalisée une structure de type micromécanique.

On réalise alors des ouvertures 108, par exemple dans la couche utile 106, formant ainsi des accès à la couche sacrificielle 104 (voir figure 2). Dans le premier mode de réalisation décrit ici, les ouvertures 108 sont réalisées en mettant à profit des étapes de photolithographie et de gravure, par exemple de type RIE (gravure ionique réactive), mises en oeuvre pour réaliser et mettre en forme la structure du MEMS 100, c'est-à-dire les différents éléments du MEMS 100.

Les ouvertures 108 sont par exemple des tranchées délimitant une portion 109 de la couche utile 106, formant un premier élément du MEMS 100 tel qu'un élément mobile du MEMS 100, par exemple une membrane suspendue si le MEMS 100 est un capteur. Dans l'exemple de réalisation décrit, la portion 109 est destinée à être mobile principalement selon l'axe y représenté sur la figure 3.

On réalise alors une gravure partielle de la couche sacrificielle 104 par l'intermédiaire des ouvertures 108 précédemment réalisées. La couche sacrificielle 104 étant ici à base d'oxyde de silicium, cette gravure peut par exemple être réalisée par de l'acide fluorhydrique. Comme représenté sur la figure 3, la totalité de la couche sacrificielle 104 n'est pas gravée. On forme ainsi une cavité 110, disposée entre la couche utile 106 et le substrat 102, dans laquelle une ou plusieurs portions 112 de la couche sacrificielle 104 sont conservées, formant ici des espaceurs entre la portion 109 de la couche utile 106 et le substrat 102. Le nombre de ces espaceurs et leur répartition sont adaptés en fonction de la portion 109, notamment en fonction de la taille et de la forme de la portion 109. Sur l'exemple de la figure 3, la portion 112 de la couche sacrificielle 104 s'étend entre la portion 109 de la couche utile 106 et le substrat 102, c'est-à-dire est en contact avec la portion 109 de la couche utile 106 et avec le substrat 102.

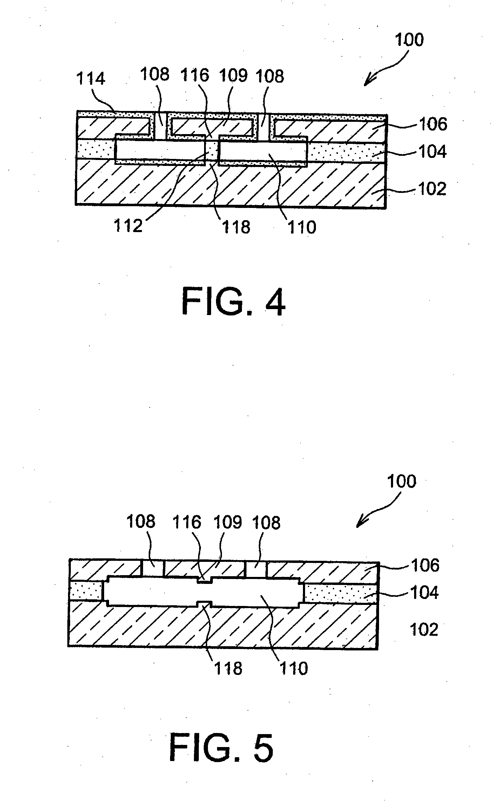

On réalise alors une étape d'oxydation thermique du silicium du MEMS 100. Sur la figure 4, on voit que toutes les parois de silicium du MEMS 100 sont oxydées, formant une couche d'oxyde 114. Cette oxydation peut par exemple être réalisée dans une profondeur de silicium par exemple comprise entre environ 200 Å et 2000 Å. Cette oxydation peut par exemple être obtenue par un traitement thermique par voie humide à 800°C, par exemple pendant quelques heures. Sur la figure 4, la face avant de la couche utile 106, les parois dans les ouvertures 108 ainsi que les parois de silicium dans la cavité 110 sont oxydées. Dans une variante, la couche d'oxyde 114 peut également être obtenue par une croissance d'oxyde, par exemple sur une épaisseur comprise entre environ 600 Å et 6000 Å.

Cette oxydation permet de pré-former des butées anti-collage dans la couche utile 106 et/ou dans le substrat 102, au niveau des zones en contact avec des portions de la couche sacrificielle 104 présentes dans la cavité 110. Dans l'exemple décrit ici, le substrat 102 et la couche utile 106 sont à base de silicium. Etant donné que la portion 112 de la couche sacrificielle 104 est en contact à la fois avec le substrat 102 et avec la couche utile 106, l'oxydation réalisée pré-forme des butées à la fois dans le substrat 102 et dans la couche utile 106 (butées 116 et 118 sur la figure 4). La ou les portions de la couche sacrificielle 104 présentes dans la cavité 110 forment donc un masque, permettant la réalisation de butées anti-collage au niveau des portions du substrat 102 et/ou de la couche utile 106 en contact avec la ou les portions de la couche sacrificielle 104.

Il est également possible que le substrat 102 et la couche utile 106 ne soient pas à base du même matériau. Ainsi, il est possible que l'oxydation se réalise uniquement dans l'un du substrat 102 ou de la couche utile 106, l'autre n'étant pas affecté par cette étape d'oxydation. Ainsi, des butées peuvent être réalisées uniquement dans le substrat 102 ou dans la couche utile 106. Des butées peuvent également être formées successivement dans le substrat 102, puis dans la couche utile 106, ou inversement. Enfin, il est également possible que la ou les portions de la couche sacrificielle 104 conservées dans la cavité 110 ne soient en contact qu'avec la couche utile 106 ou le substrat 102. Dans ce cas, des butées sont formées uniquement dans la couche en contact avec les portions de la couche sacrificielle 104, c'est-à-dire soit le substrat 102, soit la couche utile 106.

Comme représenté sur la figure 5, on réalise ensuite une élimination de l'oxyde précédemment formé ainsi que des portions 112 de la couche sacrificielle 104 conservées dans la cavité 110. Cette élimination est par exemple réalisée par la mise en oeuvre d'une gravure. La portion 109 de la couche utile 106 qui est ici l'élément mobile du MEMS 100, est donc libérée, ou désolidarisée, du substrat 102, sauf éventuellement à des endroits particuliers pour conserver par exemple des ancrages mécaniques de la structure pré-libérée.

Les butées anti-collage 116 et 118 permettent de maintenir à distance la portion 109 de la couche utile 106 du substrat 102, et ainsi d'éviter un collage intempestif entre cette portion 109 et le substrat 102 lors d'un déplacement de la portion 109 par rapport au substrat 102.

Des moyens électroniques, non représentés, peuvent ensuite être réalisés sur le dispositif 100, par exemple lorsque celui-ci réalise une mesure du déplacement de la portion 109 lors de son fonctionnement. Un capot, non représenté, peut également être réalisé sur la couche utile 106, recouvrant et protégeant le dispositif 100.

Un second mode de réalisation du procédé de réalisation du dispositif 100 est décrit ci-dessous.

On réalise tout d'abord les étapes précédemment décrites en liaison avec les figures 1 à 3.

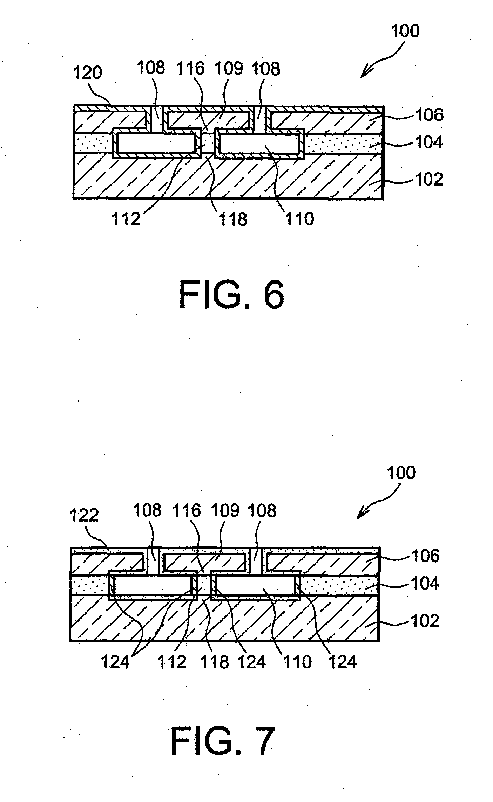

Comme représenté sur la figure 6, on réalise ensuite un dépôt métallique 120 sur toutes les parois du MEMS 100. Le dépôt métallique 120 est suffisamment conforme pour permettre le recouvrement des parois de la cavité 110 au moins au niveau de la couche utile 106 et du substrat 102. Avantageusement, cette couche métallique 120 peut être déposée par ALD (dépôt de couche atomique). La couche 120 peut notamment être à base de nickel et/ou de titane, et avoir une épaisseur comprise entre environ 200 Å et 2000 Å.

Après cette étape de dépôt métallique, on met en oeuvre un traitement thermique permettant de transformer la couche métallique 120 en une couche de siliciure 122, au moins au niveau de la couche utile 106 et du substrat 102 (figure 7). Seules des portions métalliques 124 en contact avec la couche sacrificielle 104, qui n'ont pas été transformées en siliciure, peuvent être présentes dans la cavité 110, comme c'est le cas sur la figure 7.

Une ou plusieurs étapes de gravure sélective permettent d'éliminer ces portions métalliques 124, la couche de siliciure 122 ainsi que la portion 112 de la couche sacrificielle 104 présente dans la cavité 110. Si la couche métallique 120 précédemment déposée est à base de titane, cette gravure est par exemple réalisée à partir d'une solution de HF qui permet de réaliser en une seule étape la gravure du métal (portions 124), du siliciure (couche 122) et de l'oxyde sacrificiel (portion 112). Le dispositif 100 ainsi obtenu est par exemple similaire au dispositif 100 représenté sur la figure 5.

Quelque soit le mode de réalisation, la transformation chimique réalisée (oxydation ou siliciuration) peut également affecter les parois latérales et la face arrière du dispositif lorsqu'elles ne sont pas protégées, sans compromettre la réalisation de la ou les butées anti-collage.

## Revendications

1. Procédé de réalisation d'un dispositif micromécanique et/ou nanomécanique (100) comportant au moins les étapes de :
- gravure partielle d'au moins une couche sacrificielle (104) disposée entre une première couche (106) et un substrat (102), formant au moins une cavité (110) dans laquelle est disposée au moins une portion (112) de la couche sacrificielle (104) en contact avec la première couche (106) et/ou le substrat (102),
- transformation chimique d'au moins une paroi de la première couche (106) et/ou du substrat (102) dans la cavité (110), délimitant au moins une butée (116, 118) dans la première couche (106) et/ou le substrat (102) au niveau de la portion (112) de la couche sacrificielle (104),
- élimination de ladite portion (112) de la couche sacrificielle (104) et de la paroi transformée chimiquement de la première couche (106) et/ou du substrat (102), libérant la butée (116, 118).

2. Procédé selon la revendication 1, l'étape de transformation chimique comportant au moins une oxydation thermique de la paroi de la première couche (106) et/ou du substrat (102).

3. Procédé selon la revendication 1, l'étape de transformation chimique comportant au moins un dépôt d'une couche métallique (120) sur la paroi de la première couche (106) et/ou du substrat (102), et une siliciuration de la couche métallique (120).

4. Procédé selon la revendication 3, la couche métallique (120) étant à base de titane et/ou de nickel.

5. Procédé selon la revendication 3, la couche métallique (120) étant à base de titane, la paroi de la première couche (106) et/ou du substrat (102) étant à base de silicium, et la siliciuration étant réalisée par au moins un traitement thermique à une température égale à environ 700°C.

6. Procédé selon l'une des revendications précédentes, la gravure partielle étant réalisée à travers au moins une ouverture (108) formée à travers la première couche (106).

7. Procédé selon l'une des revendications précédentes, la première couche (106) étant à base d'au moins un semi-conducteur et/ou la couche sacrificielle (104) étant à base d'au moins un oxyde de semi-conducteur et/ou le substrat (102) étant à base d'au moins un semi-conducteur.

8. Procédé selon l'une des revendications précédentes, l'étape de gravure étant obtenue par la mise en oeuvre d'une gravure humide ou en phase vapeur.

9. Procédé selon l'une des revendications précédentes, la transformation de la paroi étant réalisée sur une épaisseur comprise entre environ 200 Å et 2000 Å.

10. Procédé selon l'une des revendications précédentes, la hauteur de la butée (116, 118) correspondant à l'épaisseur éliminée de la paroi transformée chimiquement de la première couche (106) et/ou du substrat (102).

11. Procédé selon l'une des revendications précédentes, comportant en outre, après l'étape d'élimination de ladite portion (112) de la couche sacrificielle (104), une étape de réalisation d'un capot sur la première couche (106).

## Patentansprüche

1. Verfahren zur Herstellung eines mikromechanischen und/oder nanomechanischen Elements (100) durch wenigstens folgende Schritte :
- partielle Ätzung von wenigstens einer Opferschicht (104), enthalten zwischen einer ersten Schicht (106) und einem Substrat (102), um wenigstens einen Hohlraum (110) zu bilden, der wenigstens ein Teilstück (112) der Opferschicht (104), in Kontakt mit der ersten Schicht (106) und/oder dem Substrat (102), enthält,
- chemische Umwandlung wenigstens einer Wand der ersten Schicht (106) und/oder des Substrats (102) in dem Hohlraum (110), um wenigstens einen Anschlag (116, 118) in der ersten Schicht (106) und/oder dem Substrat (102) in Höhe des Teilsstücks (112) der Opferschicht (104) abzugrenzen,
- Freilegung des Anschlags (116, 118) durch Eliminieren des genannten Teilstücks (112) der Opferschicht (104) und der chemisch umgewandelten Wand der ersten Schicht (106) und/oder des Substrats (102).

2. Verfahren nach Anspruch 1, wobei der Schritt zur chemischen Umwandlung wenigstens eine thermische Oxidation der Wand der ersten Schicht (106) und/oder des Substrats (102) umfasst.

3. Verfahren nach Anspruch 1, wobei der Schritt zur chemischen Umwandlung wenigstens eine Abscheidung einer metallischen Schicht (120) auf der Wand der ersten Schicht (106) und/oder des Substrats (102) und eine Silizidierung der metallischen Schicht (120) umfasst.

4. Verfahren nach Anspruch 3, wobei die metallische Schicht (120) eine auf Titan- und/oder Nickelbasis ist.

5. Verfahren nach Anspruch 3, wobei die metallische Schicht eine auf Titanbasis ist, die Wand der ersten Schicht (106) und/oder des Substrats (102) eine auf Siliciumbasis ist, und die Silizidierung durch wenigstens eine thermische Behandlung bei einer Temperatur von ungefähr 700°C realisiert wird.

6. Verfahren nach einem der vorhergehenden Ansprüche, wobei das partielle Ätzen durch wenigstens eine in der ersten Schicht (106) gebildete Öffnung (108) hindurch erfolgt.

7. Verfahren nach einem der vorhergehenden Ansprüche, wobei die erste Schicht (106) eine auf der Basis von wenigstens einem Halbleiter ist und/oder die Opferschicht (104) eine Schicht auf der Basis von wenigstens einem Halbleiteroxid ist und/oder das Substrat (102) eines auf der Basis von wenigstens einem Halbleiter ist.

8. Verfahren nach einem der vorhergehenden Ansprüche, wobei der Ätzschritt eine Naß- oder Dampfphasenätzung umfasst.

9. Verfahren nach einem der vorhergehenden Ansprüche, wobei die Umwandlung der Wand über eine zwischen ungefähr 200 Å und 2000 Å enthaltene Dicke realisiert wird.

10. Verfahren nach einem der vorhergehenden Ansprüche, wobei die Höhe des Anschlags (116, 118) der von der chemisch umgewandelten Wand der ersten Schicht (106) und/oder des Substrats (102) eliminierten Dicke entspricht.

11. Verfahren nach einem der vorhergehenden Ansprüche, außerdem - nach dem Schritt zur Eliminierung des genannten Teilstücks (112) der Opferschicht (104) - einen Schritt zur Realisierung einer Abdeckung auf der ersten Schicht (106) umfassend.

## Claims

1. Method for producing a micromechanical and/or nanomechanical device (100) comprising at least the steps of:
- partial etching of at least one sacrificial layer (104) arranged between a first layer (106) and a substrate (102), forming at least one cavity (110) in which is arranged at least one portion (112) of the sacrificial layer (104) in contact with the first layer (106) and/or the substrate (102),
- chemical transformation of at least one wall of the first layer (106) and/or the substrate (102) in the cavity (110), delimiting at least one stop (116, 118) in the first layer (106) and/or the substrate (102) at the portion (112) of the sacrificial layer (104),
- elimination of said portion (112) of the sacrificial layer (104) and the chemically transformed wall of the first layer (106) and/or the substrate (102), freeing the stop (116, 118).

2. Method according to claim 1, wherein the chemical transformation step comprises at least one thermal oxidation of the wall of the first layer (106) and/or the substrate (102).

3. Method according to claim 1, wherein the chemical transformation step comprises at least one deposition of a metal layer (120) on the wall of the first layer (106) and/or the substrate (102), and a silicidation of the metal layer (120).

4. Method according to claim 3, wherein the metal layer (120) is based on titanium and/or nickel.

5. Method according to claim 3, wherein the metal layer (120) is based on titanium, the wall of the first layer (106) and/or the substrate (102) is based on silicon, and the silicidation is carried out by at least one heat treatment at a temperature equal to around 700°C.

6. Method according to one of the previous claims, wherein the partial etching is carried out through at least one opening (108) formed through the first layer (106).

7. Method according to one of the previous claims, wherein the first layer (106) is based on at least one semi-conductor and/or the sacrificial layer (104) is based on at least one semi-conductor oxide and/or the substrate (102) is based on at least one semi-conductor.

8. Method according to one of the previous claims, wherein the etching step is obtained by the implementation of a wet or vapour phase etching.

9. Method according to one of the previous claims, wherein the transformation of the wall is carried out over a thickness between around 200 Å and 2000 Å.

10. Method according to one of the previous claims, the height of the stop (116, 118) corresponding to the thickness eliminated from the chemically transformed wall of the first layer (106) and/or the substrate (102).

11. Method according to one of the previous claims, further comprising, after the elimination step of said portion (112) of the sacrificial layer (104), a step of forming a cover on the first layer (106).
